(19) Europäisches Patentamt

European Patent Office

Office européen des brevets

(11) Veröffentlichungsnummer : **0 321 438 B1**

# (12) EUROPÄISCHE PATENTSCHRIFT

(45) Veröffentlichungstag der Patentschrift :
**22.01.92 Patentblatt 92/04**

(51) Int. Cl.$^5$ : **H01L 41/18**

(21) Anmeldenummer : **88890287.1**

(22) Anmeldetag : **14.11.88**

(54) Piezoelektrisches Kristallelement und Verfahren zur Herstellung desselben.

(30) Priorität : **15.12.87 AT 3313/87**

(43) Veröffentlichungstag der Anmeldung :
**21.06.89 Patentblatt 89/25**

(45) Bekanntmachung des Hinweises auf die
Patenterteilung :
**22.01.92 Patentblatt 92/04**

(84) Benannte Vertragsstaaten :
**BE CH DE FR GB IT LI NL SE**

(56) Entgegenhaltungen :
**EP-A- 0 069 112**

(73) Patentinhaber : **AVL Gesellschaft für
Verbrennungskraftmaschinen und
Messtechnik mbH.Prof.Dr.Dr.h.c. Hans List
Kleiststrasse 48
A-8020 Graz (AT)**

(72) Erfinder : **Posch, Uwe, Dipl.-Ing.
Custozzagasse 1
A-8020 Graz (AT)**
Erfinder : **Krempl, Peter W., Dr.
Kainbach 211
A-8047 Graz/Ragnitz (AT)**
Erfinder : **Engel, Günter, Dipl-. Ing.Dr.
Dorfstrasse 58
A-8430 Leitring (AT)**

(74) Vertreter : **Krause, Walter, Dr. Dipl.-Ing. et al
Postfach 200 Singerstrasse 8
A-1010 Wien (AT)**

EP 0 321 438 B1

## Beschreibung

Die Erfindung betrifft ein piezoelektrisches Kristallelement aus einem Mischkristall, welcher der Gruppe der Metallorthophosphate und -orthoarsenate mit der Summenformel $A^{III} B^V O_4$ angehört, wobei die Position A zumindest zum Teil durch das Element Ga besetzt ist, sowie ein Verfahren zu dessen Herstellung.

Aus der EP-A 0069112 sind bereits Phosphate und Arsenate der Metalle Gallium und Aluminium als Reinkristalle bekannt geworden, welche hervorragende piezoelektrische Eigenschaften besitzen. Diese kristallinen Substanzen, welche der Punktsymmetrieklasse 32 angehören und eine quarzhomöotype Struktur aufweisen, können für piezoelektrische Einrichtungen wie Ultraschallwandler, Ultraschallresonatoren, akustische Modulatoren, Kristalloszillatoren, Frequenznormale, Uhren, Oberflächenwellengeräte, Mikro- und Hydrophone sowie Meßwertaufnehmer zur Messung mechanischer Größen wie Kraft, Beschleunigung oder Druck verwendet werden.

Bei unterschiedlichster Anwendung der piezoelektrischen Kristallelemente gibt es einige Kriterien die in Summe oder zumindest zum Großteil für alle Piezoelemente zutreffen müssen. Es sind dies Temperaturbeständigkeit, geringe Temperaturabhängigkeit der "Figur of Merit", hoher Q-Faktor, mechanische und chemische Stabilität, leichte Bearbeitbarkeit, kostengünstige synthetische Herstellbarkeit, sowie keine Pyroelektrizität.

Kristalle bekannter Kristallelemente haben je nach Zusammensetzung punktuell vorgegebene Eigenschaften : so weist z.B. $GaPO_4$ einen E-Modul von 70 000 N/mm² in Richtung der piezoelektrischen Kristallachse auf, während bei $AlPO_4$ dieser Meßwert 75 000 N/mm² beträgt. Auch andere relevante physikalische Konstanten, wie Dichte, Piezokonstanten, akustische Dichte etc. sind für jeden Kristall durch einen bestimmten materialabhängigen Zahlenwert vorgegeben. Daraus ergeben sich für jede Kristallvariante Eigenschaften im Bezug auf Ihre An wendung. Beispielsweise ist die Dicke d für eine bestimmte Resonatorfrequenz f durch die Formel

$$f = (1/2d) * \sqrt{(E/D)}$$

vorgegeben, da das E-Modul und die Dichte D fixiert sind.

Durch die Verwendung anderer Kristallsubstanzen mit unterschiedlichem E-Modul, sowie einem anderen Dichtewert D, kann bei vorgegebener Dicke d die Frequenz nur in bestimmten diskontinuierlichen Schritten geändert werden.

Bei der Anwendung von Kristallelementen für einen Meßwertaufnehmer, z.B. einen Druckaufnehmer, ist ein bestimmter materialabhängiger Querspannungsmodul vorgegeben, sodaß die Anpassung des aus Kristallelementen aufgebauten Meßelementes an das Gehäusematerial nur für bestimmte Werte möglich ist. Wünschenswert wäre jedoch eine kontinuierliche Variation der Eigenschaften über eine gewisse Bandbreite, um die genannten Nachteile beseitigen zu können.

Nachteile ergeben sich auch bei der synthetischen Herstellung von Einkristallen mancher Metallorthophosphate oder Metallorthoarsenate, da entsprechende Keimlinge nicht erhältlich sind und aufwendig hergestellt werden müssen.

Ein Mischkristall der eingangs genannten Art ist aus der JP-A 56114899 bekannt, bei welchem $AlPO_4$-Einkristalle mit einem Gruppe-III-Element, beispielsweise mit Sc, Y, La, Ga oder In dotiert werden. Mit der Dotierung, d.h. dem Zusatz von Gruppe-III-Elementen in Größenordnungen unter einem Atomprozent sollen die Eigenschaften von $AlPO_4$ ganz allgemein verbessert werden. Nachteiligerweise sind jedoch für viele Anwendungsgebiete — beispielsweise im Hochtemperaturbereich — Kristalle auf der Basis von $AlPO_4$ weitgehend ungeeignet.

Aufgabe der vorliegenden Erfindung ist es, die angeführten Nachteile zu vermeiden und Kristallelemente vorzuschlagen, die besser an die vom jeweiligen Verwendungszweck abhängigen Parameter angepaßt sind.

Diese Aufgabe wird erfindungsgemäß dadurch gelöst, daß Ga mindestens 50% der Kationen stellt, daß zumindest eine der Positionen A oder B mit zumindest zwei chemischen Elementen besetzt ist, wobei A außer für Ga für die dreiwertigen Elemente Al, Fe und Mn, sowie B für die fünfwertigen Elemente P und As steht und von jedem der zusätzlich in den Positionen A oder B vorhandenen Elementen zumindest 1 Atomprozent vorhanden ist.

Im Gegensatz zum eingangs erwähnten Stand der Technik wird hier von $GaPO_4$ als Grundmaterial ausgegangen, welches in vielen Punkten bessere Eigenschaften aufweist als $AlPO_4$ und nur in jenem Ausmaß durch andere Elemente ersetzt wird, als die positiven Eigenschaften der Reinsubstanz, wie Temperaturbeständigkeit, geringe Temperaturabhängigkeit der "Figur of Merit", hoher Q-Faktor, etc. großteils erhalten bleiben. Als weiterer Vorteil ist anzusehen, daß bekannte Zuchtprozesse, wie sie z.B. für die in der EP-A 0069112 genannten Materialien angeführt sind, praktisch ohne technische Änderungen übernommen werden können.

Aufgrund der vielfältigen Anwendungen piezoelektrischer Kristallelemente ist es von großem Vorteil, wenn die physikalischen Parameter des Kristallelementes durch dessen Zusammensetzung bestimmt werden und nicht durch aufwendige Konstruktion der Halterung, der Elektronik oder durch Kühlung des Einsatzbereiches auf den gewünschten Wert kompensiert werden müssen. Durch die Anwendung von Mischkristallen auf der Basis von $GaPO_4$ ergibt sich folglich eine wesentliche Erweiterung der Einsatzmöglichkeiten piezoelektrischer Kristallelemente.

Erfindungsgemäß sind Kristallelemente von besonderem Vorteil, welche sich durch die Summenformel

$$(Ga^{III}_x \, Al^{III}_{1-x})BO_4$$

auszeichnen, wobei $0{,}50 \leq x \leq 0.99$ gilt und B für P und/oder As steht. Dabei kann das in der Anschaffung teure Gallium zum Teil durch das billigere Aluminium ersetzt werden, ohne daß eine wesentliche Beeinträchtigung der Hochtemperatureignung des Kristallelementes eintritt. Mit einer bloßen Dotierung von $AlPO_4$ mit einem Gruppe-III-Element entsprechend der JP-A 56114899 kann dieser Effekt jedoch nicht erzielt werden.

Da die Zellengröße entlang der kristallographischen x-Achse für Quarz (4,914 Å) zwischen Berlinit = $AlPO_4$ (4,942 Å) und $GaPO_4$ (4,902 Å) liegt, kann z.B. durch ein geeignetes Verhältnis der Mischung von $AlPO_4$ und $GaPO_4$ im Kristall der Wert der Zellengröße des entstehenden Mischkristalls dem des Quarz angepaßt werden, wenn erfindungsgemäß in einem Gallium-Aluminium-Phosphat 3 bis 4 Atomprozent, vorzugsweise 3,23 Atomprozent Al vorhanden sind. Es können somit Quarzkeimlinge zum Züchten dieser (Ga, Al)-Mischkristalle verwendet werden, wobei ein Weiterwachsen des entstehenden Mischkristalls ohne Versetzungen möglich ist. Vorteilhafterweise werden dabei Quarzplatten insbesondere z-Schnitte als Keimlinge verwendet. Es ist natürlich auch möglich Galliumarsenaten Aluminium beizumischen, oder als Zuschlagstoff Fe oder Mn zu verwenden, um die Zellengröße von Quarz zu erhalten. Prinzipiell ist diese Vorgangsweise somit bei allen Mischkristallen möglich, die Gallium enthalten.

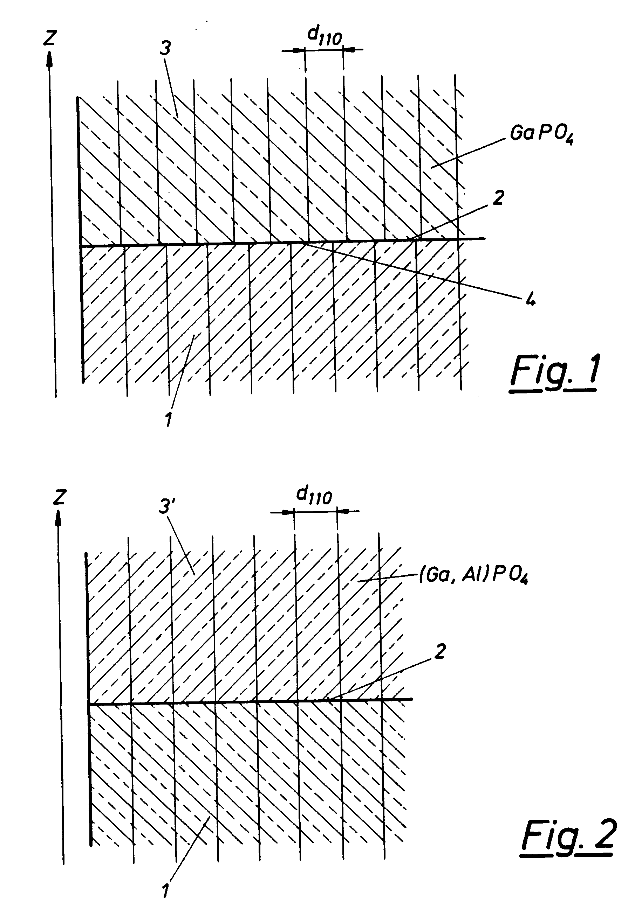

In diesem Zusammenhang wird auf die unten noch näher erläuterten Figuren 1 und 2 verwiesen.

In einer Weiterbildung der Erfindung ist vorgesehen, daß für ein Gallium-Aluminium-Phosphat $0{,}6 < x < 0{,}7$, vorzugsweise $x = 2/3$ gilt. Als Beispiel sei hier jenes Metallorthophosphat genannt, bei dem 2/3 der Kationen Gallium und 1/3 Aluminium sind. Diese Verbindung zeigt neben seiner billigen Herstellung aufgrund des relativ hohen Al-Anteils eine gegenüber der Reinkomponente ($GaPO_4$) überraschend hohe Wachstumsrate. Bei der Zucht ist der Aluminiumgehalt in der Lösung niedriger zu halten, als der gewünschte Wert im entstehenden Kristallelement, da das Aluminium im Verhältnis zum Gallium besser in den Kristall eingebaut wird.

Erfindungsgemäß ist weiters vorgesehen, daß als Kationen zusätzlich Fe und/oder Mn vorhanden sind, vorzugsweise entsprechend der Summenformel

$$(Ga^{III}_x Al^{III}_y Mn^{III}_z Fe^{III}_{1-x-y-z}) \, (P_u As_{1-u})O_4,$$

wobei $x > 0{,}5$ ; $0{,}5 > y > 0{,}3$ ; $z > 0.05$ ; $(1-x-y-z) > 0{,}05$ und $0{,}01 < u < 0{,}99$ ist. Besondere Vorteile ergeben sich bei der Verwendung derartiger Kristallelemente in Oberflächenwellenfiltern zur Kodierung von Funk- oder Telephonsignalen zwecks Abhörsicherung. Mit Hilfe eines solchen Filters lassen sich Signale über die Formgebung von interdigitalen Fingern, welche auf dem piezoelektrischen Substrat angeordnet sind, derart transformieren (sog. Konvolution), daß sie nur über einen Filter identischer Bauart decodiert werden können. Da auch die Substrateigenschaften in das Konvolutionsresultat eingehen, ergeben sich bei der erfindungsgemäßen Verwendung besagter Kristallelemente praktisch unbegrenzte Möglichkeiten von jeweils nur einmal vorhandenen Codier-Decodier-Elementen. Wenn man für dieses Filterpaar Kristallelemente auswählt, die man z.B. in Klein-Zuchtautoklaven mit jeweils nur einmal präparierter Zuchtlösung züchtet, so ist praktisch ausgeschlossen, daß auch bei Kenntnis des Aufbaues des Codierelementes das entsprechende Decodierglied nachgebaut werden kann, womit sich eine perfekte Abhörsicherung ergibt. Damit diese Aufgabe möglichst gut gelöst werden kann, ist eine große Vielfalt der zu verwendenden Elemente für $A^{III}$ und $B^v$ wünschenswert. Da man auch das Einbauverhältnis Lösung/Kristall für jedes Element in Abhängigkeit von der Matrix kennen muß, ist zum Nachbau eines Filterelementes eine chemische Analyse alleine nicht ausreichend. Es eignen sich dafür erfindungsgemäß auch Kristallelemente welche durch die Summenformel

$$(GA^{III}_x C^{III}_{1-x})BO_4,$$

gekennzeichnet sind, wobei $0{,}50 \leq x \leq 0{,}99$ gilt, B für P und/oder As und C für Fe und/oder Mn steht.

Schließlich ist es erfindungsgemäß auch möglich Kristallelemente, welche durch die Summenformel

$$Ga^{III}(P_u As_{1-u})O_4$$

vorzugsweise mit $0{,}84 < u < 0{,}85$ beschrieben werden, zu verwenden. Bei einem Arsenanteil von 15 bis 16 Atomprozent der B-Atome ist ebenfalls die Zucht mit Quarzkeimen möglich.

Ein Verfahren zur Herstellung eines erfindungsgemäßen Kristallelementes sieht vor, daß die Gitterkonstante des entstehenden Mischkristalls durch die Wahl und das Verhältnis der einzelnen Komponenten der Zuchtlösung an die Gitterkonstante von Quarz angepaßt wird.

Die Erfindung wird im folgenden anhand der Fig. 1 und 2 näher erläutert. Es zeigen :

Fig. 1       einen $GaPO_4$-Kristall auf einem Quarzkeim nach dem Stand der Technik und

Fig. 2       einen $(Ga, Al)PO_4$-Mischkristall auf einem Quarzkeim nach der Erfindung.

In den Fig. 1 und 2 ist jeweils schematisch ein Quarzkeim 1 dargestellt, an dessen Grenzflächen 2 sich ein synthetischer Zuchtkristall und zwar in Fig. 1 ein $GaPO_4$-Kristall 3, sowie in Fig. 2 ein $(Ga, Al)PO_4$-Mischkristall 3' ausbildet.

In beiden Figuren werden schematisch Netzebenen parallel zur kristallographischen z-Achse angedeutet, wobei hier als Beispiel die 110-Kristallebene gewählt wurde. Der Netzebenenabstand $d_{110}$ dieser Ebenen ist nur vom Wert der Gitterkonstante a abhängig und beträgt für

$AlPO_4$      $d_{110} = 3.026$ Å
$GaPO_4$     $d_{110} = 3.002$ Å
Quarz      $d_{110} = 3.003$ Å.

Wie aus Fig. 1 ersichtlich ergeben sich Versetzungen 4 im Kristallgitter, wenn die Werte für die Netzebenenabstände unterschiedlich groß sind. Durch eine geeignete Mischung $(Ga_xAl_{1-x})PO_4$ beispielsweise für $x = 0,96 – 0,97$, kann dieser Wert, wie aus Fig. 2 ersichtlich, dem von Quarz angepaßt werden, womit Quarz als Keimling einsetzbar ist. Durch die Anpassung des entstehenden Kristalls an die kristallographischen Daten des Quarz, kann die Versetzungsdichte in der entstehenden Kristallstruktur wesentlich vermindert werden. Zusätzliche Vorteile ergeben sich aus der leichten Verfügbarkeit und dem günstigen Preis von Quarzkeimen im Gegensatz zu anderen Keimlingen die erst mühsam hochgezüchtet werden müssen.

## Patentansprüche

1. Piezoelektrisches Kristallelement aus einem Mischkristall, welcher der Gruppe der Metallorthophosphate und -orthoarsenate mit der Summenformel $A^{III}B^{V}O_4$ angehört, wobei die Position A zumindest zum Teil durch das Element Ga besetzt ist, **dadurch gekennzeichnet,** daß Ga mindestens 50% der Kationen stellt, daß zumindest eine der Positionen A oder B mit zumindest zwei chemischen Elementen besetzt ist, wobei A außer für Ga für die dreiwertigen Elemente Al, Fe und Mn sowie B für die fünfwertigen Elemente P und As steht und von jedem der zusätzlich in den Positionen A oder B vorhandenen Elementen zumindest ein Atomprozent vorhanden ist.

2. Piezoelektrisches Kristallelement nach Anspruch 1, **gekennzeichnet durch** die Summenformel

$$(Ga^{III}_x Al^{III}_{1-x})BO_4,$$

wobei $0,50 \leq x \leq 0.99$ gilt und B für P und/oder As steht.

3. Piezoelektrisches Kristallelement nach Anspruch 2, **dadurch gekennzeichnet,** daß in einem Gallium-Aluminium-Phosphat 3 bis 4 Atomprozent, vorzugsweise 3,23 Atomprozent Al vorhanden sind.

4. Piezoelektrisches Kristallelement nach Anspruch 2, **dadurch gekennzeichnet,** daß für ein Gallium-Aluminium-Phosphat $0,6 < x < 0,7$, vorzugsweise $x = 2/3$ gilt.

5. Piezoelektrisches Kristallelement nach Anspruch 3 oder 4, **dadurch gekennzeichnet,** daß als Kationen zusätzlich Fe und/oder Mn vorhanden sind.

6. Piezoelektrisches Kristallelement nach Anspruch 5, **gekennzeichnet durch** die Summenformel

$$(Ga^{III}_x Al^{III}_y Mn^{III}_z Fe^{III}_{1-x-y-z}) (P_u As_{1-u})O_4,$$

wobei $x > 0,5$ ; $0,5 > y > 0,3$ ; $z > 0.05$ ; $(1-x-y-z) > 0,05$ und $0,01 < u < 0,99$ ist.

7. Piezoelektrisches Kristallelement nach Anspruch 1, **gekennzeichnet durch** die Summenformel

$$(Ga^{III}_x C^{III}_{1-x})BO_4,$$

wobei $0,50 \leq x \leq 0,99$ gilt, B für P und/oder As und C für Fe und/oder Mn steht.

8. Piezoelektrisches Kristallelement nach Anspruch 1, **gekennzeichnet durch** die Summenformel

$$Ga^{III}(P_uAs_{1-u})O_4,$$

vorzugsweise mit $0,84 < u < 0,85$.

9. Verfahren zur Herstellung eines piezoelektrischen Kristallelementes nach einem der Ansprüche 1 bis 7, **dadurch gekennzeichnet,** daß die Gitterkonstante des entstehenden Mischkristalls durch die Wahl und das Verhältnis der einzelnen Komponenten der Zuchtlösung an die Gitterkonstante von Quarz angepaßt wird.

## Claims

1. A piezoelectric crystal element made from a mixed crystal belonging to the group of metal orthophosphates and orthoarsenates with a total molecular formula of $A^{III}B^{V}O_4$, with position A being at least partly taken by the element Ga, wherein Ga supplies at least 50% of the cations, and **wherein** at least two chemical elements are put into at least one of positions A and B, A standing for the trivalent elements Al, Fe, Mn in addition to Ga, and B for the pentavalent elements P, As, and each of the additional elements in position A or B being provided at an atomic percentage of $\geq 1\%$.

2. A piezoelectric crystal element according to claim 1, wherein the molecular formula is

$$(Ga^{III}_xAl^{III}_{1-x})BO_4,$$

with $0.5 \leq x \leq 0.99$, and B standing for P and/or As.

3. A piezoelectric crystal element according to claim 2, wherein 3 to 4 atom% Al, preferably 3.23 atom% Al, are cotained in a gallium-aluminium-phosphate.

4. A piezoelectric crystal element according to claim 2, consisting of gallium-aluminium-phosphate with $0.6 < x < 0.7$, wherein x is preferably equal 2/3.

5. A piezoelectric crystal element according to claim 3 or 4, wherein Fe and/or Mn cations are added.

6. A piezoelectric crystal element according to claim 5, wherein the molecular formula is

$$(Ga^{III}_xAl^{III}_yMn^{III}_zFe^{III}_{1-x-y-z}) (P_uAs_{1-u})O_4,$$

with $x > 0.5$ ; $0.5 > y > 0.3$ ; $z > 0.05$ ; $(1-x-y-z) > 0.05$, and $0.01 < u < 0.39$,

7. A piezoelectric crystal element according to claim 1, wherein the molecular formula is

$$(Ga^{III}_xC^{III}_{1-x})BO_4$$

with $0.5 \leq x \leq 0.99$, B standing for P and/or As, C for Fe and/or Mn.

8. A piezoelectric crystal element according to claim 1, wherein the molecular formula is

$$Ga^{III}(P_uAs_{1-u})O_4,$$

preferably with $0.84 < u < 0.85$.

9. A method of producing a piezoelectric crystal element according to any of claims 1 to 7, wherein the lattice constant of the mixed crystal obtained in this way is matched with the lattice constant of quartz by suitably selecting and proportioning the individual components of the growing solution.

## Revendications

1. Elément de cristal piézo-électrique provenant d'un cristal mixte qui appartient au groupe des orthophosphates et orthoarséniates métalliques, avec la formule globale $A^{III}B^VO_4$, la position A étant occupée au moins en partie par l'élément Ga, caractérisé en ce que Ga représente au moins 50% des cations, qu'au moins l'une des positions A ou B est occupée par deux éléments chimiques, A représentant, en dehors de Ga, les éléments trivalents Al, Fe, Mn et B les éléments pentavalents P et As, et dont l'élément supplémentaire en position A ou B a une concentration d'au moins 1 pourcent atomique.

2. Elément de cristal piézo-électrique selon la revendication 1, caractérisé par la formule globale :

$$(Ga^{III}{}_x Al^{III}{}_{1-x})BO_4$$

dans laquelle on a : $0,50 \leq x \leq 0,99$ et B représente P et/ou As.

3. Elément de cristal piézo-électrique selon la revendication 2, caractérisé en ce que dans un phosphate de gallium et d'aluminium, il y a de 3 à 4 pour cents atomiques, de préférence 3,23 pour cents atomiques d'Al.

4. Elément de cristal piézo-électrique selon la revendication 2, caractérisé en ce que pour un phosphate de gallium et d'aluminium, on a $0,6 < x < 0,7$, de préférence $x = 2/3$.

5. Elément de cristal piézo-électrique selon la revendication 3 ou 4, caractérisé en ce qu'il y a en plus comme cation Fe et/ou Mn.

6. Elément de cristal piézo-électrique selon la revendication 5, caractérisé par la formule globale :

$$(Ca^{III}{}_x Al^{III}{}_y Mn^{III}{}_z Fe^{III}{}_{1-x-y-z})(P_u As_{1-u})O_4$$

dans laquelle on a : $x > 0,5$ ; $0,5 > y > 0,3$ ; $z > 0,05$ ; $(1-x-y-3) > 0,05$ et $0,01 < u < 0,99$.

7. Elément de cristal piézo-électrique selon la revendication 1, caractérisé par la formule globale :

$$(Ga^{III}{}_x C^{III}{}_{1-x})BO_4$$

dans laquelle on a : $0,50 \leq x \leq 0,99$, B représente P et/ou As et C représente Fe et/ou Mn.

8. Elément de cristal piézo-électrique selon la revendication 1, caractérisé par la formule globale :

$$Ga^{III}(P_u As_{1-u})O_4$$

de préférence avec $0,84 < u < 0,85$.

9. Procédé de préparation d'un élément de cristal piézo-électrique selon l'une des revendications 1 à 7, caractérisé en ce que la constante du réseau de mélange de cristal naissant s'adapte par le choix et le rapport des éléments séparés de la solution mère à la constante de réseau du quartz.

$d_{110}$

3

$GaPO_4$

2

4

1

_Fig. 1_

$d_{110}$

3'

$(Ga, Al)PO_4$

2

1

_Fig. 2_